(19)

Europäisches Patentamt
European Patent Office
Office européen des brevets

(11) **EP 4 207 314 B1**

(12) **EUROPEAN PATENT SPECIFICATION**

(45) Date of publication and mention
of the grant of the patent:
**11.03.2026 Bulletin 2026/11**

(21) Application number: **21879376.8**

(22) Date of filing: **12.10.2021**

(51) International Patent Classification (IPC):
*H10F 19/00* (2025.01)     *H10F 19/90* (2025.01)
*H10F 71/00* (2025.01)     *H01L 21/02* (2006.01)
*C30B 29/06* (2006.01)     *C30B 33/00* (2006.01)
*B28D 5/00* (2006.01)

(52) Cooperative Patent Classification (CPC):
**B28D 5/00; C30B 29/06; C30B 33/00; H10F 19/00;
H10F 19/902; H10F 71/121; H10P 90/12;**
Y02E 10/50; Y02P 70/50

(86) International application number:
**PCT/CN2021/123305**

(87) International publication number:
**WO 2022/078332 (21.04.2022 Gazette 2022/16)**

(54) **SILICON WAFER AND PREPARATION METHOD THEREFOR, CELL SHEET, CELL SLICE, CELL STRING, AND PHOTOVOLTAIC MODULE**

SILIZIUMWAFER UND HERSTELLUNGSVERFAHREN DAFÜR, ZELLSCHICHT, ZELLSTRANG UND FOTOVOLTAISCHES MODUL

TRANCHE DE SILICIUM ET SON PROCÉDÉ DE PRÉPARATION, FEUILLE DE CELLULE, TRANCHE DE CELLULE, CHAÎNE DE CELLULES ET MODULE PHOTOVOLTAÏQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.10.2020   CN 202011085318
28.07.2021   CN 202110860560**

(43) Date of publication of application:
**05.07.2023   Bulletin 2023/27**

(73) Proprietors:
• **Shanghai Ja Solar Technology Co., Ltd.
Shanghai 201401 (CN)**
• **Ja Solar Technology Yangzhou Co., Ltd.
Yangzhou, Jiangsu 225131 (CN)**

(72) Inventors:
• **CHEN, Daoyuan
Yangzhou, Jiangsu 225131 (CN)**
• **WANG, Ying
Yangzhou, Jiangsu 225131 (CN)**
• **ZHOU, Yanfang
Yangzhou, Jiangsu 225131 (CN)**

(74) Representative: **Sun, Yiming
HUASUN Patent- und Rechtsanwälte
Friedrichstraße 33
80801 München (DE)**

(56) References cited:
CN-A- 108 068 221     CN-A- 109 326 665
CN-A- 110 137 284     CN-A- 110 137 284
CN-A- 111 037 766     CN-A- 111 223 949
CN-A- 111 463 301     CN-U- 207 320 133
US-A1- 2011 120 531     US-A1- 2019 051 789
US-A1- 2019 296 171     US-A1- 2020 251 355
US-B1- 10 593 537

## Description

The invention claims priorities to CN Patent Application No. 202011085318.6, entitled "Silicon Wafer, Cell Sheet, Cell Slice, Cell String, and Stitch-Welded Solar Module", which was filed on October 12, 2020, and CN Patent Application No. 202110860560.4, entitled "Silicon Wafer and Preparation Method Therefor, Cell Sheet, Cell Slice, Cell String, and Photovoltaic Module", which was filed on July 28, 2021.

## TECHNICAL FIELD

The invention relates to the technical field of photovoltaic modules, and in particular relates to a silicon wafer and a preparation method therefor, a cell sheet, a cell slice, a cell string, and a photovoltaic module.

## BACKGROUND ART

Photovoltaic modules include photovoltaic modules with monocrystalline silicon wafers and photovoltaic modules with polycrystalline silicon wafers. An existing monocrystalline silicon wafer 110 includes two structures, in which:

As for the first structure, with reference to FIG. 1, the monocrystalline silicon wafer 110 is a rounded square slice. The rounded square slice is made into a cell sheet and cut into cell slices 120, and the plurality of cell slices 120 are connected by welding ribbons 130 in a manner as shown in FIG. 2, a sheet gap 141 is formed between two adjacent cell slices 120, and an arrangement is performed to obtain an arrangement manner as shown in FIG. 3. The photovoltaic module has sheet gaps 141, string gaps 142 and corner gaps 143, and the arrangement density of the cell slices 120 is low, which results in a comparatively low efficiency of the photovoltaic module.

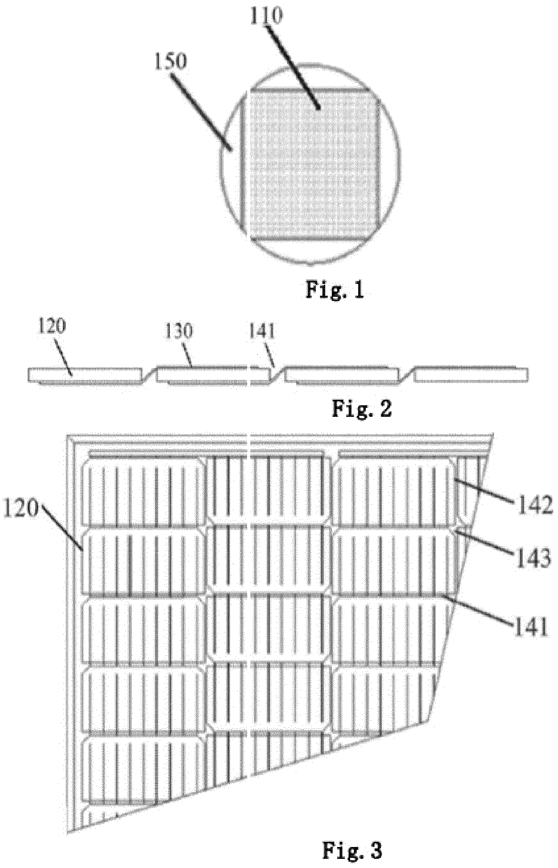

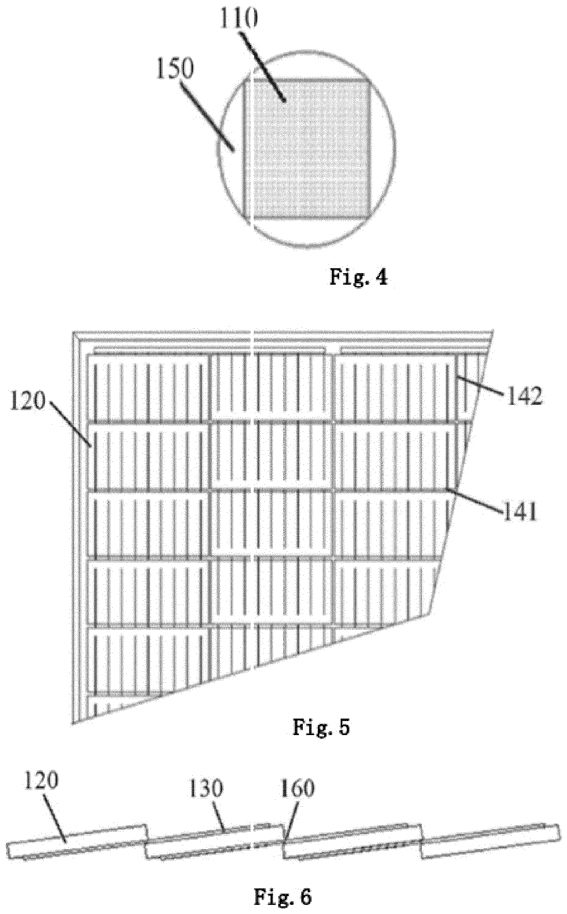

As for the second structure, with reference to FIG. 4, the monocrystalline silicon wafer 110 is a right-angled square slice inscribed in a monocrystalline silicon rod 150. The right-angled square slice is made into a cell sheet and cut into cell slices 120, and the plurality of cell slices 120 are connected by welding ribbons 130 in a manner as shown in FIG. 2, a sheet gap 141 is formed between two adjacent cell slices 120, and an arrangement is performed to obtain an arrangement manner as shown in FIG. 5. The corner gaps of the photovoltaic module are reduced relative to the corner gaps 143 in the photovoltaic module corresponding to the monocrystalline silicon wafer 110 with the first structure, but there are still sheet gaps 141 and string gaps 142, and the arrangement density of the cell slices 120 is comparatively low, which results in a comparatively low efficiency of the photovoltaic module.

By continuing to use the cell slices as an example, the arrangement density of the cell slices 120 may be increased by arranging the cell slices 120 in a stitch-welding manner as shown in FIG. 6. However, an overlapped area 160 between the cell slice 120 and the cell slice 120 will cause the cell slice 120 above to shield light of the cell slice 120 below, which reduces the output power of the photovoltaic module.

In addition, the polycrystalline silicon wafer has a structure similar to that of the monocrystalline silicon wafer, and also has problems of a low power and a low efficiency in the manufactured photovoltaic module. Examples of related prior art are described in patent publications US 2019/296171 A1, US 2019/051789 A1, CN 111 223 949 A, CN 109 326 665 A, CN 111 463 301 A, CN 110 137 284 A, US 2020/251355 A1 and US 2011/120531 A1.

## SUMMARY OF THE INVENTION

The invention is set out in the appended set of claims. One of the objects of the invention is to overcome the defects in the prior art, thereby providing a silicon wafer and a preparation method therefor, a cell sheet, a cell slice, a cell string, and a photovoltaic module with both of a high power and a high efficiency. A first aspect of the invention provides a monocrystalline silicon wafer, wherein the monocrystalline silicon wafer comprises a silicon wafer main body and an extension edge that extends outwards from an edge of the silicon wafer main body, the silicon wafer main body is a right-angled square slice or a rounded square slice, the extension edge is a ribbon-shaped structure parallel to the edge of the silicon wafer main body, and the extension edge is used to overlap below the adjacent monocrystalline silicon wafer during welding.

A second aspect of the invention provides a method for preparing the monocrystalline silicon wafer as involved in the first aspect, wherein the method comprises:

performing axial cutting on a monocrystalline silicon rod, and respectively cutting out two transverse parallel sides and two longitudinal parallel sides, wherein a distance a between the two longitudinal parallel sides is smaller than a distance b between the two transverse parallel sides; and

performing radial line cutting on the squared monocrystalline silicon rod to obtain several of the monocrystalline silicon wafers.

A third aspect of the invention provides a cell sheet, wherein the cell sheet is made of the monocrystalline silicon wafer as mentioned in the first aspect by texturing, diffusing, etching and coating steps in sequence, and wherein several main grid lines are printed on the front and back surfaces of the cell sheet respectively, and the main grid lines are arranged to be perpendicular to the extension edge.

A fourth aspect of the invention provides a cell slice, wherein the cell slice is obtained by cutting the cell sheet as mentioned in the third aspect, and at least one of the cell slices includes the extension edge.

A fifth aspect of the invention provides a method for cutting the cell sheet as mentioned in the third aspect, wherein the method comprises:

evenly cutting the cell sheet with at least one cutting line along a direction perpendicular to the main grid line to obtain several of the cell slices, each of which has the same length and same width.

A sixth aspect of the invention provides a method for cutting the cell sheet as mentioned in the third aspect, wherein the method comprises:

evenly cutting the silicon wafer main body of the cell sheet with at least one cutting line along a direction perpendicular to the main grid line to obtain several of the cell slices.

A seventh aspect of the invention provides a cell string, wherein the cell string is formed by stitch-welding several of the cell slices as involved in the fourth aspect, and the extension edges of the cell slices overlap below the adjacent cell slices.

A eighth aspect of the invention provides a photovoltaic module, wherein the photovoltaic module comprises a light-transmitting plate, a back plate, a frame, and a cell plate formed by connecting several of the cell strings as recited in the seventh aspect in series and/or in parallel, and wherein the light-transmitting plate, the cell plate and the back plate are sequentially laminated from top to bottom to form one piece, and are built in the frame.

A ninth aspect of the invention provides a polycrystalline silicon wafer, wherein the polycrystalline silicon wafer comprises a silicon wafer main body and an extension edge that extends outwards from an edge of the silicon wafer main body, the silicon wafer main body is in a square shape, the extension edge is a ribbon-shaped structure parallel to the edge of the silicon wafer main body, and the extension edge is used to overlap below the adjacent polycrystalline silicon wafer during welding.

A tenth aspect of the invention provides a method for preparing the polycrystalline silicon wafer as recited in the ninth aspect, wherein the method comprises the steps of:

performing cutting on a polycrystalline silicon block, and cutting out a plurality of transverse parallel sides and a plurality of longitudinal parallel sides, wherein a distance between any two adjacent ones of the longitudinal parallel sides is smaller than a distance between any two adjacent ones of the transverse parallel sides, to obtain polycrystalline silicon ingots; and

performing radial line cutting on the polycrystalline silicon ingot to obtain several of the polycrystalline silicon wafers.

A eleventh aspect of the invention provides a cell sheet, wherein the cell sheet is made of the polycrystalline silicon wafer as recited in the ninth aspect by texturing, diffusing, etching and coating steps in sequence, and wherein several main grid lines are printed on the front and back surfaces of the cell sheet respectively, and the main grid lines are arranged to be perpendicular to the extension edge.

A twelfth aspect of the invention provides a cell slice, wherein the cell slice is obtained by cutting the cell sheet as recited in the eleventh aspect, and at least one of the cell slices includes the extension edge.

A thirteenth aspect of the invention provides a cell string, wherein the cell string is formed by stitch-welding several of the cell slices as recited in the twelfth aspect, and the extension edges of the cell slices overlap below the adjacent cell slices.

A fourteenth aspect of the invention provides a photovoltaic module, wherein the photovoltaic module comprises a light-transmitting plate, a back plate, a frame, and a cell plate formed by connecting several of the cell strings as recited in the thirteenth aspect in series and/or in parallel, and wherein the light-transmitting plate, the cell plate and the back plate are sequentially laminated from top to bottom to form one piece, and are built in the frame.

The invention further provides a silicon wafer, wherein the silicon wafer comprises a silicon wafer main body, and each of both ends of the silicon wafer main body is provided with one extension edge; wherein

the silicon wafer main body and the extension edges are both cut from a silicon rod, the silicon wafer main body is a rounded square slice of the silicon rod or a right-angled square slice inscribed in the silicon rod, and the extension edges are ribbon-shaped, and are formed by translating outwards two oppositely arranged sides of a rounded square or an inscribed square in the silicon rod; or

the silicon wafer main body and the extension edges are both cut from an ingot-casting silicon block, and the silicon wafer is in a rectangular shape.

The silicon wafer of the invention is composed of a silicon wafer main body and an extension edge, and the silicon wafer main body may be a right-angled square slice cut from a monocrystalline silicon rod having a comparatively large diameter, or a rounded square slice cut from a monocrystalline silicon rod having a comparatively small diameter, or a square directly cut from a polycrystalline silicon block. When the silicon material is a silicon rod, the extension edge of the invention is made of the leftovers of the monocrystalline silicon rod after cutting out the silicon wafer main body, that is, the extension edge is an extension area formed by translating outwards a side of a rounded square or an inscribed square in the silicon rod by a certain distance, the extension area is ribbon-shaped with arc sides at two ends, at this time, the silicon wafer formed by cutting the monocrystalline silicon rod by the aforesaid method makes a reasonable use of the leftovers to form the extension edge relative to the existing right-angled square slice or rounded square slice, and if stitch-welding is performed, the extension edge may offset the shielded part of the silicon wafer main body, which ensures the power of the module. If a common welding arrangement is used, the extension edge may fill a sheet gap between two adjacent cell sheets, which increases the arrangement density of the cell sheets, and increases the power of the module. Similarly, when the silicon material is a polycrystalline silicon block, although its shape is regular and may be sliced directly according to the existing cutting technology, the invention differs from the existing square silicon wafer in that the silicon wafer that is cut out is in a rectangular shape, and the silicon wafer of the invention may be regarded as a rectangular silicon wafer composed of a square silicon wafer main body and a rectangular extension edge. However, whether the silicon wafer main body is cut from a monocrystalline silicon rod or a polycrystalline silicon block, it is used for the most basic part of the photoelectric conversion efficiency, and the extension edges made of the leftovers are used to solve a problem of existence of shielded areas during stitch-welding of cell sheets or existence of sheet gaps during a common arrangement of the cell sheets, thereby increasing the power and efficiency of the photovoltaic module. In addition, the existence of extension edges also makes full use of the leftovers and increases the utilization rate of the silicon material. To sum up, the silicon wafer obtained from the silicon material of a limited size in the invention may increase the power and efficiency of the photovoltaic module.

As an implementable mode, the extension edge is a stitch-welding portion used to overlap below the adjacent silicon wafer, and the extension edge has a width of L, wherein 0 <L≤2 mm.

As an implementable mode, the extension edge comprises a power generation portion and a stitch-welding portion, the power generation portion is provided between the silicon wafer main body and the stitch-welding portion, and the stitch-welding portion is used to overlap below the adjacent silicon wafer.

As an implementable mode, the power generation portion has a width of w, the stitch-welding portion has a width of d, and the extension edge has a width of **L,** and wherein w≥0.1 mm; O<d≤2 mm; 0<L≤6 mm.

Another object of the invention is to provide a cell sheet made of the aforesaid silicon wafer, the cell sheet comprising the silicon wafer, wherein several main grid lines are provided on the front and back surfaces of the cell sheet respectively, and the main grid lines are arranged to be perpendicular to the extension edge.

Another object of the invention is to provide a cell slice, which is cut from the cell sheet, wherein when the silicon wafer in the cell sheet is cut from a silicon rod, the cell slice is a cell half cut out along a direction perpendicular to the main grid line;

when the silicon wafer in the cell sheet is cut from an ingot-casting silicon block, the cell slice is in a rectangular shape and is a 1/n slice of the cell sheet, and n is a positive integer greater than or equal to 2.

A further object of the invention is to provide a cell string, wherein the cell string is formed by stitch-welding cell slices, the extension edge of each of the cell slices comprises a power generation portion and a stitch-welding portion, and the stitch-welding portion is used to be arranged below the cell slice adjacent thereto.

As an implementable mode, the stitch-welding portion in each of the cell slices has a width of 0-2 mm.

A still further object of the invention is to provide a stitch-welded solar module, which comprises several of the cell strings that are connected in series.

As compared with the prior art, the invention has the following beneficial effects:

The monocrystalline silicon wafer, polycrystalline silicon wafer, cell sheet or cell slice provided by the embodiments of the invention comprises a silicon wafer main body and an extension edge, and by making the extension edge overlap below the adjacent monocrystalline silicon wafer, polycrystalline silicon wafer, cell sheet or cell slice, a sheet gap is avoided or reduced, and an arrangement density is increased, which increases an efficiency of a photovoltaic module relative to a photovoltaic module having silicon wafer main bodies of the same size and having sheet gaps. As compared with a case of a stitch-welded photovoltaic module having silicon wafer main bodies of the same size in the prior art, since the adjacent monocrystalline silicon wafer, polycrystalline silicon wafer, cell sheet or cell slice shields the extension edge rather than the silicon wafer main body, the area of the silicon wafer main body involved in power generation is increased, and an increase in the power of the photovoltaic module is facilitated.

The silicon wafer provided by the invention makes full use of the leftovers and is substantially rectangular as a whole, the respective cell sheets in the cell string prepared thereby are closely arranged, and the extension edge made of the leftovers may connect the silicon wafer main bodies without shielding during welding of the cell sheets. When the cell sheets are welded in a common arrangement, the extension edge may fill a sheet gap between two adjacent cell sheets, which increases the arrangement density of the cell sheets, increases the power and efficiency of the photovoltaic module, and reduces the production cost.

## BRIEF DESCRIPTION OF THE DRAWINGS

The invention may be well understood, and the advantages of the invention may be presented more clearly when the detailed descriptions of the implementation solutions shown by non-limiting examples below are read. The descriptions are given with reference to the accompanying figures, where:

FIG. 1 is a schematic diagram of a rounded square slice located in a monocrystalline silicon rod in the prior art;

FIG. 2 is a schematic diagram of a structure of a cell string with sheet gaps being formed between adjacent cell slices in the prior art;

FIG. 3 is a schematic diagram of a partial structure of a photovoltaic module including cell slices made by rounded square slices arranged in the manner as shown in FIG. 2 in the prior art;

FIG. 4 is a schematic diagram of a right-angled square slice inscribed in a monocrystalline silicon rod in the prior art;

FIG. 5 is a schematic diagram of a partial structure of a photovoltaic module including cell slices made by right-angled square slices arranged in the manner as shown in FIG. 2 in the prior art;

FIG. 6 is a schematic diagram of a structure of a stitch-welded cell string in the prior art;

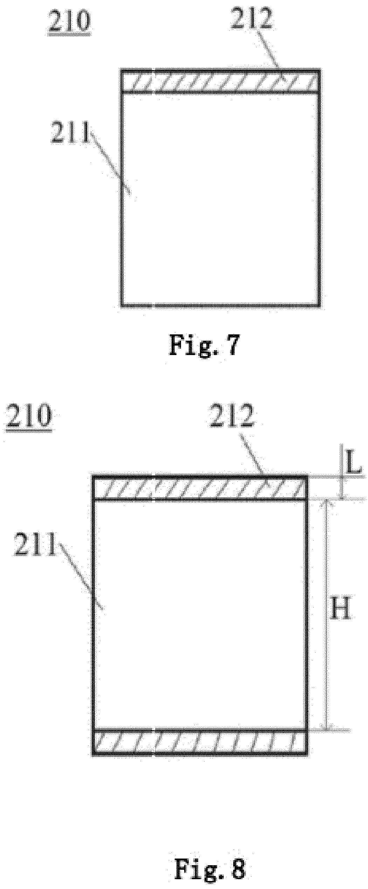

FIG. 7 is a schematic diagram of a structure of a monocrystalline silicon wafer with an extension edge provided by an embodiment of the invention;

FIG. 8 is a schematic diagram of a structure of a monocrystalline silicon wafer with two extension edges provided by an embodiment of the invention;

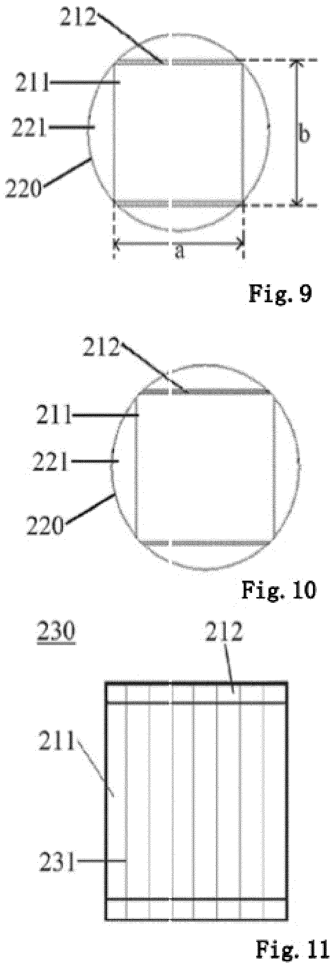

FIG. 9 is a schematic diagram of a silicon wafer body that is a right-angled square slice inscribed in a monocrystalline silicon rod provided by an embodiment of the invention;

FIG. 10 is a schematic diagram of a silicon wafer body that is a rounded square slice located in a monocrystalline silicon rod provided by an embodiment of the invention;

FIG. 11 is a schematic diagram of a structure of a cell sheet provided by an embodiment of the invention;

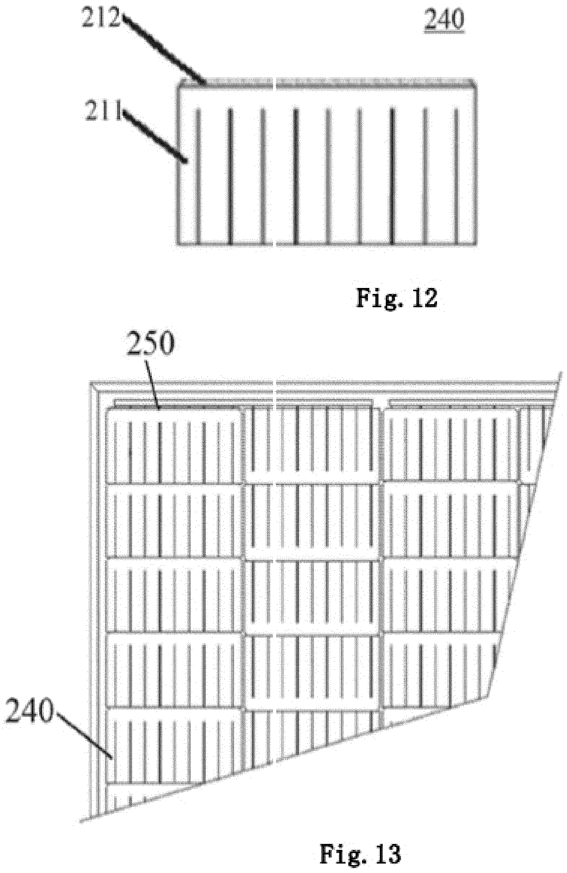

FIG. 12 is a schematic diagram of a structure of a cell slice provided by an embodiment of the invention;

FIG. 13 is a schematic diagram of a partial structure of a photovoltaic module in which all extension edges of cell halves are used for stitch-welding according to an embodiment of the invention;

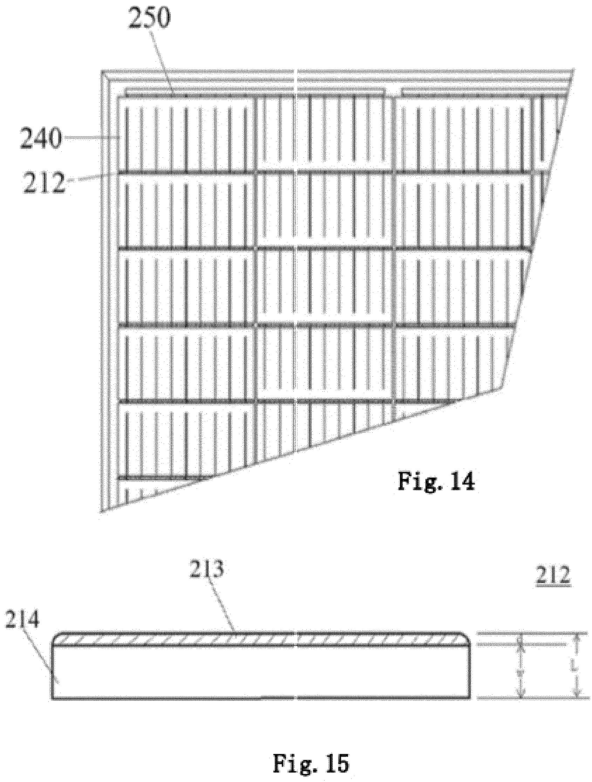

FIG. 14 is a schematic diagram of a partial structure of a photovoltaic module in which extension edges of cell halves are partially used for stitch-welding according to an embodiment of the invention; and

FIG. 15 is a schematic diagram of a structure of an extension edge in FIG. 14.

The reference signs include: monocrystalline silicon wafer-110, 210; silicon wafer main body-211; extension edge-212; stitch-welding portion-213; power generation portion-214; monocrystalline silicon rod-150, 220; leftover area-221; cell sheet-230; main grid line-231; cell slice-120, 240; cell string-250; welding ribbon-130; sheet gap-141; string gap-142; corner gap-143; overlapped area-160.

## DETAILED DESCRIPTION

Both the terms "above" and "below" involved in the invention are based on the direction as shown in FIG. 6. A light ray is illuminated from above, and a cell slice located below the overlapped region is shielded by a cell slice above.

In the invention, unless otherwise specified, the extension edges involved in the monocrystalline silicon wafer, the polycrystalline silicon wafer, the cell sheet and the cell slice correspond to each other, and are all named the extension edges, and the silicon wafer main bodies involved in the monocrystalline silicon wafer, the polycrystalline silicon wafer, the cell sheet and the cell slice correspond to each other, and are all named the silicon wafer main bodies.

The "transverse" direction involved in the invention is based on the horizontal direction in FIG. 9 or FIG. 10, and the "longitudinal" direction involved in the invention is based on the vertical direction in FIG. 9 or FIG. 10.

A monocrystalline silicon wafer and a preparation method therefor, a polycrystalline silicon wafer and a preparation method therefor, a cell sheet, a cell slice, a cell string, and a photovoltaic module provided by the embodiments of the invention are described in detail below:

A first aspect of the embodiments of the invention provides a monocrystalline silicon wafer 210, and with reference to FIG. 7 or FIG. 8, the monocrystalline silicon wafer 210 includes a silicon wafer main body 211 and an extension edge 212 that extends outwards from an edge of the silicon wafer main body 211, the silicon wafer main body 211 is a right-angled square slice (see FIG. 4) or a rounded square slice (see FIG. 1), the extension edge 212 is a ribbon-shaped structure parallel to the edge of the silicon wafer main body 211, and the extension edge 212 is used to overlap below the adjacent monocrystalline silicon wafer 210 during welding. The extension edge 212 may be a rectangular ribbon-shaped structure, another regular ribbon-shaped structure or irregular ribbon-shaped structure, or the like. With reference to FIG. 7, the number of the extension edges 212 may be one, and with reference to FIG. 8, the number of the extension edges 212 may be two, and the two extension edges 212 are respectively arranged on two opposite edges of the silicon wafer main body 211.

The monocrystalline silicon wafer 210 provided by the embodiments of the invention includes a silicon wafer main body 211 and an extension edge 212. The size of the silicon wafer main body 211 is equal to the size of the monocrystalline silicon wafer in the prior art, and the extension edge 212 may be an extra part as compared with the monocrystalline silicon wafer in the prior art. By making the extension edge 212 overlap below the adjacent monocrystalline silicon wafer 210, a sheet gap between the monocrystalline silicon wafer 210 and the monocrystalline silicon wafer 210 is avoided or reduced, and an arrangement density of the monocrystalline silicon wafers 210 is increased, which increases an efficiency of a photovoltaic module relative to a photovoltaic module having silicon wafer main bodies 211 of the same size and having sheet gaps. As compared with a case of a stitch-welded photovoltaic module having silicon wafer main bodies 211 of the same size in the prior art, since the adjacent monocrystalline silicon wafer 210 shields the extension edge 212 rather than the silicon wafer main body 211, the area of the silicon wafer main body 211 involved in power generation is increased, and an increase in the power of the photovoltaic module is facilitated.

In some embodiments, the silicon wafer main body 211 and the extension edge 212 may be integrally cut and shaped from a squared monocrystalline silicon rod 220, with reference to FIG. 9, the right-angled square slice is inscribed in the monocrystalline silicon rod 220, and with reference to FIG. 10, the center of the rounded square slice is on the axis of the monocrystalline silicon rod 220, the rounded corners of the rounded square slice correspond to the arc surfaces of the monocrystalline silicon rod 220, and the extension edge 212 corresponds to a leftover area 221 other than an area for cutting out the silicon wafer main body 211 on the monocrystalline silicon rod 220. The manner of obtaining the monocrystalline silicon wafer 210 including a silicon wafer main body 211 and an extension edge 212 by means of integral cutting and shaping is simple and facilitates production, and obtaining the extension edge 212 by cutting the leftover area 221 not only facilitates an increase in the power and efficiency of the photovoltaic module, but also reduces the amount of the recycled leftovers and reduces the recycling cost.

In some embodiments, with continued reference to FIG. 9, the two ends of the extension edge 212 correspond to the arc surfaces of the monocrystalline silicon rod 220. In this way, the monocrystalline silicon wafer 210 including the extension edge 212 can be obtained just by axially cutting the monocrystalline silicon rod 220 by transverse parallel sides and longitudinal parallel sides without performing other cutting operations, which is simple in the cutting process and facilitates mass production.

In some embodiments, the thickness of the silicon wafer main body 211 may be equal to the thickness of the extension edge 212, so that a cutting path is conveniently controlled to obtain the monocrystalline silicon wafer 210, and part of the extension edge 212 may be used for power generation.

With continued reference to FIG. 8, the silicon wafer main body 211 may have a side length of H, and $H \geq 156$ mm. Preferably, $156$ mm $\leq H \leq 210$ mm. The side length H of the silicon wafer main body 211 may be 156 mm, 156.75 mm, 157.25 mm, 157.4 mm, 157.75 mm, 158.75 mm, 161.7 mm, 166.7 mm, 170 mm, 172 mm, 176 mm, 178 mm, 182 mm, 210 mm, or the like. Correspondingly, the extension edge 212 may have a width of L, and $0 < L \leq 6$ mm. Preferably, $O < L \leq 4$ mm. Further preferably, $0.5 \leq L \leq 2.3$ mm. By means of such arrangement, the extension edge 212 can be cut from the leftover area 221, and the extension edge 212 with such width also facilitates a stable support of the monocrystalline silicon wafer 210 above.

A second aspect of the embodiments of the invention provides a method for preparing any of the monocrystalline silicon wafers 210 as involved in the first aspect, wherein the method includes:

Step 11: performing axial cutting on a monocrystalline silicon rod 220, and respectively cutting out two transverse parallel sides and two longitudinal parallel sides, where with reference to FIG. 9, a distance a between the two longitudinal parallel sides is smaller than a distance b between the two transverse parallel sides. In other words, cutting is performed along the axial direction of the monocrystalline silicon rod 220 to square the monocrystalline silicon rod 220 to form a rectangular parallelepiped columnar structure.

In step 11, the two longitudinal parallel sides may coincide with the edges of the right-angled square inscribed in the monocrystalline silicon rod 220, so that the silicon wafer main body of the right-angled square slice can be obtained by cutting, or the two longitudinal parallel sides may coincide with the edges of the rounded square, so that the silicon wafer main body of the rounded square slice can be obtained by cutting, and the two transverse parallel sides may be loaded in the leftover area 221.

Step 12: performing radial line cutting on the squared monocrystalline silicon rod 220 to obtain several of the monocrystalline silicon wafers 210. Each of the monocrystalline silicon wafers 210 is a rectangular sheet-shaped structure, and each of the monocrystalline silicon wafers 210 includes an extension edge 212. The "radial line cutting" refers to cutting along the diameter direction of the monocrystalline silicon rod, that is, cutting along the direction perpendicular to the axis of the monocrystalline silicon rod.

The preparation method for the monocrystalline silicon wafer 210 provided by the embodiments of the invention performs axial cutting on the monocrystalline silicon rod 220 by two transverse parallel sides and two longitudinal parallel sides, and makes a distance a between the two longitudinal parallel sides be smaller than a distance b between the two transverse parallel sides, so that the squared monocrystalline silicon rod 220 is subjected to the radial line cutting to obtain the monocrystalline silicon wafer 210 that is a rectangular sheet-shaped structure. The preparation method is simple, and may be achieved just by adjusting the distance b between the two transverse parallel sides. By making the extension edge 212 of the monocrystalline silicon wafer 210 overlap below the adjacent monocrystalline silicon wafer 210, an increase in the power and efficiency of the photovoltaic module is facilitated.

In some embodiments,

$$\frac{156}{156 + 6} \leqslant \frac{a}{b} \leqslant \frac{210}{210 + 0.1}$$, where the ratio of a to b may be 0.964, 0.970, 0.975, 0.980, 0.985, 0.990, 0.995, or the like. In this way, the monocrystalline silicon wafer 210 obtained by cutting may be made to have one extension edge 212.

In some embodiments,

$$\frac{156}{156 + 2 * 6} \leqslant \frac{a}{b} \leqslant \frac{210}{210 + 2 * 0.1}$$,

where the ratio of a to b may be 0.930, 0.935, 0.940, 0.945, 0.950, 0.955, 0.960, 0.965, 0.970, 0.975, 0.980, 0.985, 0.990, 0.995, or the like. In this way, the monocrystalline silicon wafer 210 obtained by cutting may be made to have two extension edges 212.

A third aspect of the embodiments of the invention provides a cell sheet 230, wherein the cell sheet 230 is made of any of the monocrystalline silicon wafers 210 as involved in the first aspect by texturing, diffusing, etching and coating steps in sequence, and with reference to FIG. 11, several main grid lines 231 are printed on the front and back surfaces of the cell sheet respectively, and the main grid lines 231 are arranged to be perpendicular to the extension edge 212. The extension edge 212 is a ribbon-shaped structure and extends along the edge of the silicon wafer main body 211, and the main grid lines 231 are perpendicular to the direction in which the extension edge 212 extends. The texturing step includes: corroding the surface of the silicon wafer with an acid or alkali liquid to remove impurities on the surface of the silicon wafer, and forming a textured surface on the surface of the silicon wafer to increase the light reflectivity of the surface of the silicon wafer. The diffusing step includes: forming a diffusion layer containing dopant elements on the surface of the monocrystalline silicon wafer 210, where the dopant elements in the diffusion layer may be diffused into the monocrystalline silicon wafer 210 in a thermal diffusion manner to form a **PN** junction. The etching step includes: removing the diffusion layer and a silicon dioxide layer formed on the surface of the monocrystalline silicon wafer 210 by wet etching, so as to avoid the impact on the power generation performance of the monocrystalline silicon wafer 210. The coating step includes: coating a silicon nitride anti-reflection film on the surface of the monocrystalline silicon wafer 210 to increase the photoelectric conversion efficiency of the photovoltaic module.

Several main grid lines 231 may be printed on the front and back surfaces of the silicon wafer main body 211 and the extension edge 212 corresponding to the cell sheet 230, so that part of the extension edge 212 may also be used for power generation and current collection. Several main grid lines 231 may be printed on the front and back surfaces of the silicon wafer main body 211 corresponding to the cell sheet 230, there may be no main grid lines 231 on the extension edge 212, and the extension edge 212 may be shielded by the cell sheet 230 above without being used for power generation.

Based on that the monocrystalline silicon wafer 210 includes a silicon wafer main body 211 and an extension edge 212, the cell sheet 230 provided by the embodiments of the invention also includes a silicon wafer main body 211 and an extension edge 212. The size of the silicon wafer main body 211 may be equal to the size of the cell sheet 230 in the prior art, and the extension edge 212 may be an extra part as compared with the cell sheet 230 in the prior art. By making the extension edge 212 overlap below the adjacent cell sheet 230, a sheet gap between the cell sheet 230 and the cell sheet 230 is avoided or reduced, and an arrangement density of the cell sheets 230 is increased, which increases an efficiency of a photovoltaic module relative to a photovoltaic module having silicon wafer main bodies 211 of the same size and having sheet gaps. As compared with a case of a stitch-welded photovoltaic module having silicon wafer main bodies 211 of the same size in the prior art, since the adjacent cell sheet 230 shields the extension edge 212 rather than the silicon wafer main body 211, the area of the silicon wafer main body 211 involved in power generation is increased, and an increase in the power of the photovoltaic module is facilitated.

A fourth aspect of the embodiments of the invention provides a cell slice 240, wherein the cell slice 240 is obtained by cutting any of the cell sheets 230 as provided in the third aspect, and with reference to FIG. 12, at least one of the cell slices 240 includes the extension edge 212.

Based on that the cell sheet 230 includes a silicon wafer main body 211 and an extension edge 212, the cell slice 240 provided by the embodiments of the invention includes a silicon wafer main body 211 and an extension edge 212. The size of the silicon wafer main body 211 may be equal to the size of the cell slice 240 in the prior art, and the extension edge 212 may be an extra part as compared with the cell slice 240 in the prior art. By making the extension edge 212 overlap below the adjacent cell slice 240, a sheet gap between the cell slice 240 and the cell slice 240 is avoided or reduced, and an arrangement density of the cell slices 240 is increased, which increases an efficiency of a photovoltaic module relative to a photovoltaic module having silicon wafer main bodies 211 of the same size and having sheet gaps. As compared with a case of a stitch-welded photovoltaic module having silicon wafer main bodies 211 of the same size in the prior art, since the adjacent cell slice 240 shields the extension edge 212 rather than the silicon wafer main body 211, the area of the silicon wafer main body 211 involved in power generation is increased, and an increase in the power of the photovoltaic module is facilitated.

In some embodiments, a cutting line for cutting the cell sheet 230 is perpendicular to the main grid line 231, and the cell slice 240 is a cell half of the cell sheet 230. The cell sheet 230 may be evenly cut into two cell halves by one cutting line, so that the two cell halves have the same size. Alternatively, the cell sheet 230 may be cut into two cell halves of different sizes by one cutting line.

In some embodiments, the cutting line for cutting the cell sheet 230 is perpendicular to the main grid line 231, the cell slice 240 is a 1/n slice of the cell sheet 230, and n is a positive integer greater than or equal to 2, e.g., n may be 3, 4, 5, or the like. The cell sheet 230 may be evenly cut into at least three cell slices 240 by at least two cutting lines, so that each of the cell slices 240 has the same size. Alternatively, the cell sheet 230 may be cut into at least three cell slices 240 of different sizes by at least two cutting lines.

Cutting in any of the aforesaid manners may make any two of the cell slices 240 have the same length and same width. The aspect ratio of the cell slice 240 may be 1.85-1.99, and preferably, the aspect ratio of the cell slice 240 may be 1.89-1.92, e.g., the ratio may be 1.89, 1.90, 1.91, 1.92, or the like.

Cutting in any of the aforesaid manners may make silicon wafer main body 211 areas corresponding to any two of the cell slices 240 have the same length and same width, so that some cell slices 240 do not include the extension edges 212, and overlap the extension edges 212 of other cell slices 240 to increase the arrangement density. In addition, the edge of the cell slice 240 not including the original extension edge 212 may also serve as an extension edge 212 to overlap the adjacent cell slice 240.

A fifth aspect of the embodiments of the invention provides a method for cutting the cell sheet 230 in the fourth aspect, wherein the method includes: evenly cutting the cell sheet 230 along at least one cutting line perpendicular to the main grid line 231 to obtain several of the cell slices 240, each of which has the same length and same width. Although the cell slice 240 located in the middle of the silicon wafer main body 211 does not include the original extension edge 212, each of the cell slices 240 has the same length and same width, and each of the edges of the cell slices 240 may be used as the extension edge 212 to overlap below the adjacent cell slice 240.

A sixth aspect of the embodiments of the invention provides a method for cutting the cell sheet 230 in the fourth aspect, wherein the method includes: evenly cutting the silicon wafer main body 211 of the cell sheet 230 along at least one cutting line perpendicular to the main grid line 231 to obtain several of the cell slices 240. In this way, the cell slice 240 located in the middle of the wafer silicon main body 211 does not include an extension edge 212, the cell slice 240 located at the edge of the silicon wafer main body 211 includes an extension edge 212, and the extension edge 212 of the cell slice 240 may overlap the cell slice 240 not including the extension edge 212.

A seventh aspect of the embodiments of the invention provides a cell string 250, wherein the cell string 250 is formed by stitch-welding several of arbitrary ones of the cell slices 240 as provided in the fourth aspect, and with reference to FIG. 13 or FIG. 14, the extension edges 212 of the cell slices 240 overlap below the adjacent cell slices 240.

In the cell string 250 provided by the embodiments of the invention, by making the extension edge 212 of the cell slice 240 overlap below the adjacent cell slice 240, a sheet gap between the cell slice 240 and the cell slice 240 is avoided or reduced, and an arrangement density of the cell strings 250 is increased, which increases an efficiency of a photovoltaic module relative to a photovoltaic module having silicon wafer main bodies 211 of the same size and having sheet gaps. As compared with a case of a stitch-welded photovoltaic module having silicon wafer main bodies 211 of the same size in the prior art, since the adjacent cell slice 240 shields the extension edge 212 rather than the silicon wafer main body 211, the area of the silicon wafer main body 211 involved in power generation is increased, and an increase in the power of the photovoltaic module is facilitated.

In some embodiments, with reference to FIG. 13, all the extension edges 212 of the cell slices 240 overlap below the adjacent cell slices 240. Correspondingly, the extension edge 212 has a width of **L**, and $0<L\leq2$ mm, e.g., L may be 0.1 mm, 0.4 mm, 0.5 mm, 0.8 mm, 1 mm, 1.2 mm, 1.5 mm, 1.8 mm or 2 mm. In this way, the extension edge 212 is enabled to stably support the cell slice 240.

In some embodiments, with reference to FIG. 14 or FIG. 15, the extension edge 212 includes a stitch-welding portion 213 and a power generation portion 214 provided between the stitch-welding portion 213 and the silicon wafer main body 211, the stitch-welding portion 213 overlaps below the adjacent cell slice 240, and the power generation portion 214 is exposed outside the adjacent cell slice 240. In this way, the power generation portion 214 of the extension edge 212 may also be used for power generation, which facilitates an increase in the power of the photovoltaic module. Correspondingly, the extension edge 212 has a width of **L**, the power generation portion 214 has a width of w, and the stitch-welding portion 213 has a width of d, and then $0<L\leq6$ mm, e.g., L may be 0.2 mm, 0.8 mm, 1 mm, 1.5 mm, 2 mm, 2.5 mm, 3 mm, 3.5 mm, 4 mm, 4.5 mm, 5 mm, 5.5 mm or 6 mm; $w\geq0.1$ mm, e.g., w may be 0.1 mm, 0.5 mm, 1 mm, 1.5 mm, 1.8 mm, 2 mm, 2.5 mm, 3 mm, 3.5 mm, 4 mm, 4.5 mm, 5 mm, 5.5 mm, or the like; $0<d\leq2$ mm, e.g., d may be 0.1 mm, 0.5 mm, 1 mm, 1.5 mm, 2 mm, or the like. Such arrangement not only ensures that the stitch-welding portion 213 can stably support the cell slice 240, but also enables the power generation portion 214 to generate power, which increases the output power of the photovoltaic module.

A eighth aspect of the embodiments of the invention provides a photovoltaic module, wherein the photovoltaic module includes a light-transmitting plate, a back plate, a frame, and a cell plate formed by connecting several of arbitrary ones of the cell strings 250 as provided in the seventh aspect in series and/or in parallel, and wherein the light-transmitting plate, the cell plate and the back plate are sequentially laminated from top to bottom to form one piece, and are built in the frame.

As for the photovoltaic module provided in the embodiments of the invention, in the cell string 250, by making the extension edge 212 of the cell slice 240 overlap below the adjacent cell slice 240, a sheet gap between the cell slice 240 and the cell slice 240 is avoided or reduced, and an arrangement density of the cell strings 250 is increased, which increases an efficiency of a photovoltaic module relative to a photovoltaic module having silicon wafer main bodies 211 of the same size and having sheet gaps. As compared with a case of a stitch-welded photovoltaic module having silicon wafer main bodies 211 of the same size in the prior art, since the adjacent cell slice 240 shields the extension edge 212 rather than the silicon wafer main body 211, the area of the silicon wafer main body 211 involved in power generation is increased, and an increase in the power of the photovoltaic module is facilitated.

A ninth aspect of the embodiments of the invention provides a polycrystalline silicon wafer, which is similar to the monocrystalline silicon wafer, and reference may be made to the figures corresponding to the monocrystalline silicon wafer. The polycrystalline silicon wafer includes a silicon wafer main body and an extension edge that extends outwards from an edge of the silicon wafer main body, the silicon wafer main body is in a square shape, e.g., it may be a right-angled square slice or a rounded square slice, the extension edge is a ribbon-shaped structure parallel to the edge of the silicon wafer main body, and the extension edge is used to overlap below the adjacent polycrystalline silicon wafer during welding. It may be understood that the polycrystalline silicon wafer is a rectangular sheet-shaped structure, and the extension edge is located at the edge thereof.

The polycrystalline silicon wafer provided by the embodiments of the invention includes a silicon wafer main body and an extension edge. The size of the silicon wafer main body may be equal to the size of the polycrystalline silicon wafer in the prior art, and the extension edge may be an extra part as compared with the polycrystalline silicon wafer in the prior art. By making the extension edge overlap below the adjacent polycrystalline silicon wafer, a sheet gap between the polycrystalline silicon wafer and the polycrystalline silicon wafer is avoided or reduced, and an arrangement density of the polycrystalline silicon wafers is increased, which increases an efficiency of a photovoltaic module relative to a photovoltaic module having silicon wafer main bodies of the same size and having sheet gaps. As compared with a case of a stitch-welded photovoltaic module having silicon wafer main bodies of the same size in the prior art, since the adjacent polycrystalline silicon wafer shields the extension edge rather than the silicon wafer main body, the area of the silicon wafer main body involved in power generation is increased, and an increase in the power of the photovoltaic module is facilitated.

In some embodiments, the silicon wafer main body and the extension edge may be integrally cut and shaped from a squared polycrystalline silicon ingot, and the extension edge corresponds to a leftover area other than an area for cutting out the silicon wafer main body on the polycrystalline silicon ingot. Obtaining the extension edge by cutting the leftover area not only facilitates an increase in the power and efficiency of the photovoltaic module, but also reduces the amount of the recycled leftovers and reduces the recycling cost. In some other embodiments, the silicon wafer main body and the extension edge may be integrally cut and shaped from a squared polycrystalline silicon ingot, and the extension edge is formed by the edge of the polycrystalline silicon ingot.

In some embodiments, the thickness of the silicon wafer main body may be equal to the thickness of the extension edge, so that a cutting path is conveniently controlled to obtain the polycrystalline silicon wafer, and part of the extension edge may be used for power generation.

The ratio of the long side to the short side of the polycrystalline silicon wafer is 1.01-1.07, e.g., the ratio may be 1.01, 1.02, 1.03, 1.04, 1.05, 1.06, 1.07, or the like. Further, the ratio of the long side to the short side of the polycrystalline silicon wafer is preferably 1.03-1.05.

A tenth aspect of the embodiments of the invention provides a method for preparing any of the polycrystalline silicon wafers in the ninth aspect, wherein the method includes the following steps:

Step 21: performing cutting on a polycrystalline silicon block, and cutting out a plurality of transverse parallel sides and a plurality of longitudinal parallel sides, wherein a distance between any two adjacent ones of the longitudinal parallel sides is smaller than a distance between any two adjacent ones of the transverse parallel sides, to obtain polycrystalline silicon ingots. In other words, cutting is performed on the polycrystalline silicon block to cut out a plurality of polycrystalline silicon ingots with rectangular parallelepiped columnar structures.

In step 21, at least one transverse parallel side may be located in the leftover area, so that part of the polycrystalline silicon material in the leftover area is cut out to serve as part of the polycrystalline silicon ingot with a rectangular parallelepiped columnar structure. Alternatively, the transverse parallel side may not be located in the leftover area.

Step 22: performing radial line cutting on the polycrystalline silicon ingot to obtain several of the polycrystalline silicon wafers. Each of the polycrystalline silicon wafers is a rectangular sheet-shaped structure, and at least one edge of each of the polycrystalline silicon wafers may be used as the extension edge. When the edge of the polycrystalline silicon ingot does not correspond to the leftover area, the extra part thereof as compared with the polycrystalline silicon wafer in the prior art may be used as the extension edge.

The preparation method for the polycrystalline silicon wafer provided by the embodiments of the invention performs axial cutting on the polycrystalline silicon block by two transverse parallel sides and two longitudinal parallel sides, and makes a distance between the two longitudinal parallel sides be smaller than a distance between the two transverse parallel sides to obtain a plurality of polycrystalline silicon ingots. By performing radial line cutting on the polycrystalline silicon ingot, polycrystalline silicon wafers that are rectangular sheet-shaped structures are obtained, which have extra extension edges relative to the sizes of the polycrystalline silicon wafers in the prior art, and a photovoltaic module obtained by stitch-welding of the polycrystalline silicon wafers has both the high power and the high efficiency. The preparation method is simple, and may be achieved just by adjusting the distance between the two transverse parallel sides.

A eleventh aspect of the embodiments of the invention provides a cell sheet, wherein the cell sheet is made of any of the polycrystalline silicon wafers as provided in the ninth aspect by texturing, diffusing, etching and coating steps in sequence, and wherein several main grid lines are printed on the front and back surfaces of the cell sheet respectively, and the main grid lines are arranged to be perpendicular to the extension edge. As for the texturing, diffusing, etching and coating steps, reference may be made to the illustrations of the cell sheet in the third aspect.

Several main grid lines may be printed on the front and back surfaces of the silicon wafer main body and the extension edge corresponding to the cell sheet, so that part of the extension edge may also be used for power generation.

Based on that the polycrystalline silicon wafer includes a silicon wafer main body and an extension edge, the cell sheet provided by the embodiments of the invention also includes a silicon wafer main body and an extension edge. The size of the silicon wafer main body may be equal to the size of the cell sheet in the prior art, and the extension edge may be an extra part as compared with the cell sheet in the prior art. By making the extension edge overlap below the adjacent cell sheet, a sheet gap between the cell sheet and the cell sheet is avoided or reduced, and an arrangement density of the cell sheets is increased, which increases an efficiency of a photovoltaic module relative to a photovoltaic module having silicon wafer main bodies of the same size and having sheet gaps. As compared with a case of a stitch-welded photovoltaic module having silicon wafer main bodies of the same size in the prior art, since the adjacent cell sheet shields the extension edge rather than the silicon wafer main body, the area of the silicon wafer main body involved in power generation is increased, and an increase in the power of the photovoltaic module is facilitated.

A twelfth aspect of the embodiments of the invention provides a cell slice, wherein the cell slice is obtained by cutting any of the cell sheets as provided in the eleventh aspect, and at least one of the cell slices includes the extension edge.

Based on that the cell sheet includes a silicon wafer main body and an extension edge, the cell slice provided by the embodiments of the invention includes a silicon wafer main body and an extension edge. The size of the silicon wafer main body may be equal to the size of the cell slice in the prior art, and the extension edge may be an extra part as compared with the cell slice in the prior art. By making the extension edge overlap below the adjacent cell slice, a sheet gap between the cell slice and the cell slice is avoided or reduced, and an arrangement density of the cell slices is increased, which increases an efficiency of a photovoltaic module relative to a photovoltaic module having silicon wafer main bodies of the same size and having sheet gaps. As compared with a case of a stitch-welded photovoltaic module having silicon wafer main bodies of the same size in the prior art, since the adjacent cell slice shields the extension edge rather than the silicon wafer main body, the area of the silicon wafer main body involved in power generation is increased, and an increase in the power of the photovoltaic module is facilitated.

In some embodiments, a cutting line for cutting the cell sheet is perpendicular to the main grid line, and the cell slice is a cell half of the cell sheet. The cell sheet may be evenly cut into two cell halves by one cutting line, so that the two cell halves have the same size. Alternatively, the cell sheet 230 may be cut into two cell halves of different sizes by one cutting line.

In some embodiments, the cutting line for cutting the cell sheet is perpendicular to the main grid line, the cell slice is a 1/n slice of the cell sheet, and n is a positive integer greater than or equal to 2. The cell sheet may be evenly cut into at least three cell slices by at least two cutting lines, so that each of the cell slices 240 has the same size. Alternatively, the cell sheet 230 may be cut into at least three cell slices 240 of different sizes by at least two cutting lines.

Cutting in any of the aforesaid manners makes any two of the cell slices have the same length and same width. The edge of the cell slice may be used as the extension edge, which overlaps below the adjacent cell slice.

A thirteenth aspect of the embodiments of the invention provides a cell string, wherein the cell string is formed by stitch-welding several of arbitrary ones of the cell slices in the twelfth aspect, and the extension edges of the cell slices overlap below the adjacent cell slices.

In the cell string provided by the embodiments of the invention, by making the extension edge of the cell slice overlap below the adjacent cell slice, a sheet gap between the cell slice and the cell slice is avoided or reduced, and an arrangement density of the cell strings is increased, which increases an efficiency of a photovoltaic module relative to a photovoltaic module having silicon wafer main bodies of the same size and having sheet gaps. As compared with a case of a stitch-welded photovoltaic module having silicon wafer main bodies of the same size in the prior art, since the adjacent cell slice shields the extension edge rather than the silicon wafer main body, the area of the silicon wafer main body involved in power generation is increased, and an increase in the power of the photovoltaic module is facilitated.

In some embodiments, all the extension edges of the cell slices overlap below the adjacent cell slices so as to stably support the cell slices.

In some embodiments, the extension edge includes a stitch-welding portion and a power generation portion provided between the stitch-welding portion and the silicon wafer main body, the stitch-welding portion overlaps below the adjacent cell slice, and the power generation portion is exposed outside the adjacent cell slice. In this way, the power generation portion of the extension edge may is also used for power generation, which facilitates an increase in the power of the photovoltaic module.

A fourteenth aspect of the embodiments of the invention provides a photovoltaic module, wherein the photovoltaic module comprises a light-transmitting plate, a back plate, a frame, and a cell plate formed by connecting several of arbitrary ones of the cell strings as provided in the thirteenth aspect in series and/or in parallel, and wherein the light-transmitting plate, the cell plate and the back plate are sequentially laminated from top to bottom to form one piece, and are built in the frame.

As for the photovoltaic module provided in the embodiments of the invention, in the cell string, by making the extension edge of the cell slice overlap below the adjacent cell slice, a sheet gap between the cell slice and the cell slice is avoided or reduced, and an arrangement density of the cell strings is increased, which increases an efficiency of a photovoltaic module relative to a photovoltaic module having silicon wafer main bodies of the same size and having sheet gaps. As compared with a case of a stitch-welded photovoltaic module having silicon wafer main bodies of the same size in the prior art, since the adjacent cell slice shields the extension edge rather than the silicon wafer main body, the area of the silicon wafer main body involved in power generation is increased, and an increase in the power of the photovoltaic module is facilitated.

As for the contents such as a polycrystalline silicon wafer and a preparation method therefor, a cell sheet, a cell slice, a cell string, and a photovoltaic module, reference may be made to the illustrations of the monocrystalline silicon wafer and its corresponding parts.

A fifteenth aspect of the embodiments of the invention provides a silicon wafer made of a monocrystalline silicon rod subjected to squaring and line cutting procedures, and with reference to FIG. 7 or FIG. 8, the silicon wafer is in a substantially rectangular shape, and includes a silicon wafer body 211 and extension edges 212 arranged at both ends of the silicon wafer main body 211, and the silicon wafer main body 211 may be a rounded square slice of a monocrystalline silicon rod or a right-angled square slice inscribed in a monocrystalline silicon rod. Reference may be made to FIG. 1 for the shape of the rounded square slice, and reference may be made to the existing process for the production standard of the rounded square slice. The extension edges 212 are ribbon-shaped bodies with respective two ends being arc edges, and are formed by translating outwards two oppositely arranged sides of a rounded square or an inscribed square in the monocrystalline silicon rod. The translation distance (i.e., the width L of the extension edge) is not greater than 6 mm for the reasons that first, the size of the monocrystalline silicon rod is limited, and second, if the translation distance is too large, since the edge of the monocrystalline silicon rod has more impurities, the efficiency of the silicon wafer after being made into a cell will be reduced.

With reference to FIG. 8, the extension edge 212 may be reasonably divided according to the translation distance. When the translation distance is within 2 mm, the extension edge 212 may be provided with only one stitch-welding portion 213, and at this time, the extension edge 212 is completely used as a connecting piece, that is, the stitch-welding portion 213 is used to overlap below the adjacent cell sheet, and the leftover area 221 is used as the part that is shielded when the connection is performed, so that the photoelectric conversion efficiency of each silicon wafer main body 211 is not affected. When the extension edge is only provided with one stitch-welding portion 213, the width d of the stitch-welding portion 213 is preferably 0.5 mm, which not only may achieve the function of connection, but also may avoid the waste of the silicon material, and the leftover area 221 other than the area used as the extension edge 212 may be recycled, which reduces the cost. As compared with the traditional silicon wafers to be stitch-welded, such arrangement has its effective photoelectric conversion positions being completely not shielded, and has a high power of the photovoltaic module.

With reference to FIG. 15, the extension edge 212 of the invention may also include a power generation portion 214, that is, the power generation portion 214 is arranged between the stitch-welding portion 213 and the silicon wafer main body 211, and it is preferable that when the translation distance is 0.5-6 mm, that is, the width L of the extension edge 212 is 0.5 mm-6 mm, the extension edge 212 is arranged as two parallel areas, with the position close to the silicon wafer main body 211 as the inside, followed by the power generation portion 214 and the stitch-welding portion 213 in sequence from the inside to the outside. When the cell sheets prepared from the silicon wafer are used to produce a cell string, only the stitch-welding portion 213 is used to overlap below the silicon wafer main body 211 of the adjacent cell sheet, and the power generation portion 214 has the same function as the silicon wafer main body 211, i.e., to perform photoelectric conversion. The power of the photovoltaic module prepared by such arrangement is higher than that of the existing cell strings that are not stitch-welded for the reasons that the extension edges 212 of the silicon wafers of the invention may fill part of the sheet gaps, which increases the arrangement density of the cell sheets. As compared with a case of a stitch-welded module, the stitch-welding portion 213 of the extension edge 212 being used for overlapping will not cause the silicon wafer main body 211 to be shielded to result in a reduced power, and the power generation portion 214 has a higher photoelectric conversion efficiency than the reflective effect of the traditional sheet gap, and especially when the width w of the power generation portion 214 is approximately equal to 4 mm, the photoelectric conversion efficiency is comparatively high. However, the width w of the power generation portion 214 cannot be too large, if the width w is too large, the silicon wafer of the power generation portion 214 has too many impurities, and the width thereof is also limited by the size of the silicon rod. In this embodiment, the preferable selection is to arrange that the width w of the power generation portion 214 is 1.8 mm, the width d of the stitch-welding portion 213 is 0.5mm, and the width L of the extension edge 212 is 2.3 mm.

As for a sixteenth aspect of the embodiments of the invention, with reference to FIG. 8, the silicon wafer of this embodiment is made by performing line cutting on a polycrystalline silicon block. The difference from the fifteenth aspect lies in that the silicon material used in this embodiment itself is the ingot-casting square material, and there will not be as many leftovers as those of the monocrystalline silicon rod during cutting, but the difference from the prior art lies in that the silicon wafer in this embodiment is cut into a rectangle, and the rectangular silicon wafer may be regarded as one made of the square silicon wafer main body 211 and the extension edges 212 arranged at both ends of the silicon wafer main body 211. The reason why the extension edges 212 are arranged is that the polycrystalline silicon block, like the monocrystalline silicon rod, has more impurities in the periphery, and if the entire polycrystalline silicon block is used for preparing the silicon wafer main body 211, the conversion efficiency of the cell sheet will be inevitably reduced. In the prior art, in order to increase the photoelectric conversion efficiency, it is possible to only cut out the core material in the middle as the silicon wafer main body 211, which, however, will result in the light shielding problem as recited in the background art of the invention, and the power of the photovoltaic module is still to be increased, so the invention arrange the extension edge 212. The specific division, size and function of the extension edge 212 are the same as those in the fifteenth aspect, and no unnecessary details are further given herein. The power of the module made of the rectangular silicon wafers prepared from a polycrystalline silicon block of the same size is higher than the power of the module made of the existing square silicon wafers.

A seventeenth aspect of the embodiments of the invention provides a cell sheet and a cell slice (with reference to FIG. 12), the cell sheet is made of the silicon wafer in the fifteenth aspect or the sixteenth aspect, and main grid lines are provided on the front and back surfaces of the cell sheet respectively, and the main grid lines are arranged to be perpendicular to the extension edge, so as to facilitate subsequent slicing to form cell slices 240.

When cutting is performed on the cell sheet, with respect to silicon wafers made of different silicon materials, the cutting manners are different. When the silicon wafer is from a silicon rod, the cell should be cut along a direction perpendicular to the main grid line 231 to form cell halves, so that it can be ensured that each cell half has an extension edge 212 to enable it to have the beneficial effects of the invention.
when the silicon wafer is cut from a polycrystalline silicon block, the number of times for performing cutting is not limited in principle, but the cutting direction should also be perpendicular to the main grid line 231, and at this time, cutting may be performed three times, four times, or the like as long as the resulting cell slice 240 is in a rectangular shape.

An eighteenth aspect of the embodiments of the invention provides a cell string and a stitch-welded solar module (with reference to FIG. 14), the cell string is formed by stitch-welding the cell slices 240 in the seventeenth aspect, and during welding, the extension edge 212 in each of the cell slices 240 is made to overlap below the silicon wafer main body in the adjacent cell half. Of course, the range of the extension edge 212 shielded by the silicon wafer main body 211 should be limited to the stitch-welding portion 213, and the width d of the stitch-welding portion 213 is preferably 0.5 mm, so that the cell slices 240 can firmly overlap, but the stitch-welding portion 213 should not be too wide so as to avoid the waste of the leftovers.

With reference to FIG. 14, the stitch-welded solar module of this embodiment is composed of the aforesaid cell strings, and the respective cell strings in the stitch-welded solar module are connected in series, with each of the cell strings being arranged in a U-shape.

The above silicon wafer provided by the invention is composed of a silicon wafer main body 211 and an extension edge 212, and the silicon wafer main body 211 is a right-angled square slice cut from a monocrystalline silicon rod having a comparatively large diameter, or a rounded square slice cut from a monocrystalline silicon rod having a comparatively small diameter, or a square directly cut from a polycrystalline silicon block. When the silicon material is a monocrystalline silicon rod, the extension edge 212 of the invention is made of the leftovers of the monocrystalline silicon rod after cutting out the silicon wafer main body 211, that is, the extension edge 212 is an extension area formed by translating outwards a side of a rounded square or an inscribed square in the made from silicon rod by a certain distance, the extension area is ribbon-shaped with arc sides at two ends, at this time, the silicon wafer formed by cutting the monocrystalline silicon rod by the aforesaid method makes a reasonable use of the leftovers to form the extension edge 212 relative to the existing right-angled square slice or rounded square slice, and if stitch-welding is performed, the extension edge 212 may offset the shielded part of the silicon wafer main body 211, which ensures the power generation power of the silicon wafer main body. If a common welding arrangement is used, the extension edge may fill a sheet gap between two adjacent cell sheets, which increases the arrangement density of the cell sheets, and increases the power and efficiency of the module. Similarly, when the silicon material is a polycrystalline silicon block, although its shape is regular and may be sliced directly according to the existing cutting technology, the invention differs from the existing square silicon wafer in that the silicon wafer that is cut out is in a rectangular shape, and the silicon wafer of the invention may be regarded as a rectangular silicon wafer composed of a square silicon wafer main body 211 and a rectangular extension edge 212. However, whether the silicon wafer main body 211 is cut from a monocrystalline silicon rod or a polycrystalline silicon block, it is used for the most basic part of the photoelectric conversion efficiency, and the extension edges 212 made of the leftovers are used to solve a problem of existence of shielded areas during stitch-welding of cell sheets or existence of sheet gaps during a arrangement of the cell sheets, thereby increasing the power and efficiency of the photovoltaic module. In addition, the extension edges 212 also make full use of the leftovers, increase the utilization rate of the silicon material, and reduce the recycling cost of the silicon material. To sum up, the monocrystalline silicon wafer and the polycrystalline silicon wafer obtained from the silicon material of a limited size in the invention may increase the power and efficiency of the photovoltaic module.

The above contents are only specific implementation modes of the invention, but the scope of protection of the invention is not limited thereto. Any change or substitution that can be easily conceived by those skilled in the art within the technical scope disclosed in the invention shall be included in the scope of protection of the invention. Thus, the scope of protection of the invention shall be based on the scopes of protection of the claims.

## Claims

1.  A monocrystalline silicon wafer (210), wherein

    the monocrystalline silicon wafer (210) comprises a silicon wafer main body (211) and an extension edge (212) that extends outwards from an edge of the silicon wafer main body (211),
    the silicon wafer main body (211) is a rounded square slice,
    the extension edge (212) is a ribbon-shaped structure parallel to the edge of the silicon wafer main body (211), and
    the extension edge (212) is configured to overlap below an adjacent monocrystalline silicon wafer (210) during welding, wherein
    the silicon wafer main body (211) and the extension edge (212) are integrally cut and shaped from a squared monocrystalline silicon rod (220),
    wherein
    a center of the rounded square slice is defined on an axis of the monocrystalline silicon rod (220),
    rounded corners of the rounded square slice correspond to arc surfaces of the monocrystalline silicon rod (220), and
    the extension edge (212) corresponds to a leftover area (221) other than an area for cutting out the silicon wafer main body (211) on the monocrystalline silicon rod (220).

2.  The monocrystalline silicon wafer (210) according to claim 1, wherein
    the silicon wafer main body (211) has a side length of H, and H≥156 mm.

3.  The monocrystalline silicon wafer (210) according to claim 2, wherein
    the extension edge (212) has a width of L, and 0<L≤6 mm.

4.  The monocrystalline silicon wafer (210) according to claim 1, wherein
    the number of the extension edges (212) is one.

5.  The monocrystalline silicon wafer (210) according to claim 1, wherein

    the number of the extension edges (212) is two, and
the two extension edges (212) are respectively arranged on two opposite edges of the silicon wafer main body (211).

6. The monocrystalline silicon wafer (210) according to claim 1, wherein
a thickness of the silicon wafer main body (211) is equal to the thickness of the extension edge (212).

7. The monocrystalline silicon wafer (210) according to claim 1, wherein
two ends of the extension edge (212) correspond to the arc surfaces of the monocrystalline silicon rod (220).

8. A method for preparing the monocrystalline silicon wafer (210) according to any of claims 1 to 7, wherein the method comprises:

performing axial cutting on a monocrystalline silicon rod (220), and respectively cutting out two transverse parallel sides and two longitudinal parallel sides, wherein a distance a between the two longitudinal parallel sides is smaller than a distance b between the two transverse parallel sides; and
performing radial line cutting on the squared monocrystalline silicon rod (220) to obtain the monocrystalline silicon wafer (210).

9. The method according to claim 8, wherein

$$\frac{156}{156+2*6} \leq \frac{a}{b} \leq \frac{210}{210+2*0.1}.$$

10. The method according to claim 8, wherein

$$\frac{156}{156+6} \leqslant \frac{a}{b} \leqslant \frac{210}{210+0.1}.$$

11. A cell string (250), wherein

the cell string (250) is formed by stitch-welding several of cell slices (240),
each cell slice (240) is obtained by cutting a cell sheet (230),
at least one of the cell slices (240) includes extension edges (212),
each cell sheet (230) is made from the monocrystalline silicon wafer (210) according to any of claims 1 to 7 by texturing, diffusing, etching and coating steps in sequence, wherein several main grid lines (231) are printed on front and back surfaces of the cell sheet (230) respectively, and the main grid lines (231) are arranged to be perpendicular to the extension edge (212), and
the extension edges (212) of the cell slices (240) overlap below the adjacent cell slices (240).

12. The cell string (250) according to claim 11, wherein all the extension edges (212) of the cell slices (240) overlap below the adjacent cell slices (240).

13. The cell string (250) according to claim 12, wherein the extension edge (212) has a width of **L,** and 0<L≤2 mm.

14. The cell string (250) according to claim 11, wherein

the extension edge (212) comprises a stitch-welding portion (213) and a power generation portion (214) provided between the stitch-welding portion (213) and the silicon wafer main body (211),
the stitch-welding portion (213) overlaps below the adjacent cell slice (240), and
the power generation portion (214) is exposed outside the adjacent cell slice (240).

**Patentansprüche**

1. Ein monokristalliner Siliziumwafer (210), wobei

der monokristalline Siliziumwafer (210) einen Siliziumwafer-Hauptkörper (211) und einen Erweiterungsrand (212), der sich von einer Kante des Siliziumwafer-Hauptkörpers (211) nach außen erstreckt, umfasst,
der Siliziumwafer-Hauptkörper (211) eine abgerundete quadratische Scheibe ist,
der Erweiterungsrand (212) eine bandförmige Struktur ist, die parallel zu der Kante des Siliziumwafer-Hauptkörpers (211) verläuft, und
der Erweiterungsrand (212) dazu ausgebildet ist, sich beim Verschweißen unter einem benachbarten monokristallinen Siliziumwafer (210) zu überlappen, wobei
der Siliziumwafer-Hauptkörper (211) und der Erweiterungsrand (212) einstückig aus einem quadratischen monokristallinen Siliziumingot (220) geschnitten und geformt sind,
wobei ein Zentrum der abgerundeten quadratischen Scheibe auf einer Achse des monokristallinen Siliziumingots (220) definiert ist,
abgerundete Ecken der abgerundeten quadratischen Scheibe den Bogenflächen des monokristallinen Siliziumingots (220) entsprechen, und
der Erweiterungsrand (212) einem Restbereich (221) entspricht, der anders als ein Bereich zum Ausschneiden des Siliziumwafer-Hauptkörpers (211) auf dem monokristallinen Siliziumingot (220) ist.

2. Der monokristalline Siliziumwafer (210) nach Anspruch 1, wobei
der Siliziumwafer-Hauptkörper (211) eine Seitenlänge H aufweist, und H≥156 mm.

3. Der monokristalline Siliziumwafer (210) nach Anspruch 2, wobei der Erweiterungsrand (212) eine Breite L aufweist, und 0<L≤6 mm.

4. Der monokristalline Siliziumwafer (210) nach Anspruch 1, wobei
die Anzahl der Erweiterungsränder (212) gleich eins ist.

5. Der monokristalline Siliziumwafer (210) nach Anspruch 1, wobei

die Anzahl der Erweiterungsränder (212) gleich zwei ist, und
die zwei Erweiterungsränder (212) jeweils an zwei gegenüberliegenden Kanten des Siliziumwafer-Hauptkörpers (211) angeordnet sind.

6. Der monokristalline Siliziumwafer (210) nach Anspruch 1, wobei
eine Dicke des Siliziumwafer-Hauptkörpers (211) gleich der Dicke des Erweiterungsrandes (212) ist.

7. Der monokristalline Siliziumwafer (210) nach Anspruch 1, wobei
zwei Enden des Erweiterungsrandes (212) den Bogenflächen des monokristallinen Siliziumingots (220) entsprechen.

8. Ein Verfahren zur Herstellung des monokristallinen Siliziumwafers (210) nach einem der Ansprüche 1 bis 7, wobei das Verfahren umfasst:

axiales Schneiden an einem monokristallinen Siliziumingot (220) durchzuführen, und jeweils zwei parallele Querseiten und zwei parallele Längsseiten auszuschneiden, wobei ein Abstand a zwischen den zwei parallelen Längsseiten kleiner ist als ein Abstand b zwischen den zwei parallelen Querseiten; und
radiales Linienschneiden an dem quadratischen monokristallinen Siliziumingot (220) durchzuführen, um den monokristallinen Siliziumwafer (210) zu erhalten.

9. Das Verfahren nach Anspruch 8, wobei

$$\frac{156}{156 + 2*6} \leq \frac{a}{b} \leq \frac{210}{210 + 2*0.1}.$$

10. Das Verfahren nach Anspruch 8, wobei

$$\frac{156}{156 + 6} \leq \frac{a}{b} \leq \frac{210}{210 + 0.1}.$$

11. Ein Zellstring (250), wobei

der Zellstring (250) durch Stichschweißen mehrerer Zellstücke (240) gebildet ist,
jedes Zellstück (240) durch Schneiden einer Zellplatte (230) erhalten wird,
wenigstens eines der Zellstücke (240) Erweiterungsränder (212) umfasst,
jede Zellplatte (230) aus dem monokristallinen Siliziumwafer (210) nach einem der Ansprüche 1 bis 7 durch nacheinander ausgeführte Schritte des Texturierens, Diffundierens, Ätzens und Beschichtens hergestellt ist, wobei mehrere Hauptgitterlinien (231) jeweils auf Vorder- und Rückseiten der Zellplatte (230) gedruckt sind, und die Hauptgitterlinien (231) so angeordnet sind, dass sie senkrecht zu dem Erweiterungsrand (212) verlaufen, und
die Erweiterungsränder (212) der Zellstücke (240) sich unterhalb der benachbarten Zellstücke (240) überlappen.

12. Der Zellstring (250) nach Anspruch 11, wobei alle Erweiterungsränder (212) der Zellstücke (240) sich unterhalb der benachbarten Zellstücke (240) überlappen.

13. Der Zellstring (250) nach Anspruch 12, wobei der Erweiterungsrand (212) eine Breite L aufweist, und 0<L≤2 mm.

14. Der Zellstring (250) nach Anspruch 11, wobei

der Erweiterungsrand (212) einen Stichschweißabschnitt (213) und einen Stromerzeugungsabschnitt (214) umfasst, der zwischen dem Stichschweißabschnitt (213) und dem Siliziumwafer-Hauptkörper (211) vorgesehen ist, der Stichschweißabschnitt (213) sich unterhalb des benachbarten Zellstücks (240) überlappt, und
der Stromerzeugungsabschnitt (214) außerhalb des benachbarten Zellstücks (240) freiliegt.

**Revendications**

1. Une plaquette de silicium monocristallin (210), dans laquelle

la plaquette de silicium monocristallin (210) comprend un corps principal de plaquette de silicium (211) et un bord d'extension (212) s'étendant vers l'extérieur à partir d'un bord du corps principal de plaquette de silicium (211),

le corps principal de plaquette de silicium (211) est une tranche carrée à coins arrondis,

le bord d'extension (212) est une structure en forme de ruban parallèle au bord du corps principal de plaquette de silicium (211), et

le bord d'extension (212) est configuré pour se chevaucher au-dessous d'une plaquette de silicium monocristallin (210) adjacente lors du soudage, dans laquelle

le corps principal de plaquette de silicium (211) et le bord d'extension (212) sont découpés et formés d'une seule pièce à partir d'un lingot de silicium monocristallin carré (220),

dans laquelle un centre de la tranche carrée à coins arrondis est défini sur un axe du lingot de silicium monocristallin (220),

les coins arrondis de la tranche carrée à coins arrondis correspondent à des surfaces en arc du lingot de silicium monocristallin (220), et

le bord d'extension (212) correspond à une zone résiduelle (221) autre qu'une zone destinée à découper le corps principal de plaquette de silicium (211) sur le lingot de silicium monocristallin (220).

2. La plaquette de silicium monocristallin (210) selon la revendication 1, dans laquelle
le corps principal de plaquette de silicium (211) a une longueur de côté H, et H$\geq$ 156 mm.

3. La plaquette de silicium monocristallin (210) selon la revendication 2, dans laquelle
le bord d'extension (212) a une largeur L, et 0<L$\leq$6 mm.

4. La plaquette de silicium monocristallin (210) selon la revendication 1, dans laquelle
le nombre de bords d'extension (212) est égal à un.

5. La plaquette de silicium monocristallin (210) selon la revendication 1, dans laquelle

le nombre de bords d'extension (212) est égal à deux, et
les deux bords d'extension (212) sont disposés respectivement sur deux bords opposés du corps principal de plaquette de silicium (211).

6. La plaquette de silicium monocristallin (210) selon la revendication 1, dans laquelle
une épaisseur du corps principal de plaquette de silicium (211) est égale à l'épaisseur du bord d'extension (212).

7. La plaquette de silicium monocristallin (210) selon la revendication 1, dans laquelle
deux extrémités du bord d'extension (212) correspondent aux surfaces en arc du lingot de silicium monocristallin (220).

8. Un procédé de préparation de la plaquette de silicium monocristallin (210) selon l'une quelconque des revendications 1 à 7, dans lequel le procédé comprend :

effectuer une découpe axiale sur un lingot de silicium monocristallin (220), et découper respectivement deux côtés transversaux parallèles et deux côtés longitudinaux parallèles, dans lequel une distance a entre les deux côtés longitudinaux parallèles est inférieure à une distance b entre les deux côtés transversaux parallèles ; et
effectuer une découpe radiale en lignes sur le lingot de silicium monocristallin carré (220) afin d'obtenir la plaquette de silicium monocristallin (210).

9. Le procédé selon la revendication 8, dans lequel

$$\frac{156}{156+2*6} \leq \frac{a}{b} \leq \frac{210}{210+2*0.1}.$$

10. Le procédé selon la revendication 8, dans lequel

$$\frac{156}{156+6} \leqslant \frac{a}{b} \leqslant \frac{210}{210+0.1}.$$

11. Une chaîne de cellules (250), dans laquelle

la chaîne de cellules (250) est formée par soudage par points de plusieurs segments de cellule (240),
chaque segment de cellule (240) est obtenu par découpe d'une feuille de cellule (230),
au moins l'un des segments de cellule (240) comprend des bords d'extension (212),
chaque feuille de cellule (230) est réalisée à partir de la plaquette de silicium monocristallin (210) selon l'une quelconque des revendications 1 à 7 par des étapes de texturation, de diffusion, de gravure et de revêtement effectuées successivement, dans laquelle plusieurs lignes principales de grille (231) sont imprimées respectivement sur des surfaces avant et arrière de la feuille de cellule (230), et les lignes principales de grille (231) sont disposées de manière à être perpendiculaires au bord d'extension (212), et
les bords d'extension (212) des segments de cellule (240) se chevauchent au-dessous des segments de cellule (240) adjacents.

12. La chaîne de cellules (250) selon la revendication 11, dans laquelle
tous les bords d'extension (212) des segments de cellule (240) se chevauchent au-dessous des segments de cellule (240) adjacents.

13. La chaîne de cellules (250) selon la revendication 12, dans laquelle le bord d'extension (212) a une largeur L, et $0 < L \leq 2$ mm.

14. La chaîne de cellules (250) selon la revendication 11, dans laquelle

le bord d'extension (212) comprend une portion de soudage par points (213) et une portion de production d'électricité (214) disposée entre la portion de soudage par points (213) et le corps principal de plaquette de silicium (211),
la portion de soudage par points (213) se chevauche au-dessous du segment de cellule (240) adjacent, et
la portion de production d'électricité (214) est exposée à l'extérieur du segment de cellule (240) adjacent.

Fig. 1

Fig. 2

Fig. 3

Fig. 4

Fig. 5

Fig. 6

Fig. 7

Fig. 8

Fig. 9

Fig. 10

Fig. 11

212

211

240

**Fig. 12**

250

240

**Fig. 13**

250

240

212

Fig. 14

213

212

214

Fig. 15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202011085318
- CN 202110860560
- US 2019296171 A1
- US 2019051789 A1
- CN 111223949 A
- CN 109326665 A
- CN 111463301 A
- CN 110137284 A
- US 2020251355 A1
- US 2011120531 A1